Europäisches Patentamt

European Patent Office

Office européen des brevets

(11) Publication number: **0 458 043 A1**

# EUROPEAN PATENT APPLICATION

(21) Application number: 91105360.1

(22) Date of filing: 04.04.91

(51) Int. Cl.⁵: **H01L 39/14**, H01L 39/24, H05K 9/00, G12B 17/02, G01R 1/18

(30) Priority: 17.04.90 JP 101491/90

(43) Date of publication of application:
27.11.91 Bulletin 91/48

(84) Designated Contracting States:
DE FR GB

(71) Applicant: NKK CORPORATION
1-2 Marunouchi 1-chome, Chiyoda-ku
Tokyo(JP)

(72) Inventor: Shimbo, Yukio, c/o NKK
CORPORATION
1-2, 1-chome, Marunouchi
Chiyoda-ku, Tokyo(JP)
Inventor: Kabasawa, Makoto, c/o NKK
CORPORATION
1-2, 1-chome, Marunouchi
Chiyoda-ku, Tokyo(JP)
Inventor: Kosuge, Shigeyoshi c/o NKK
CORPORATION
1-2, 1-chome, Marunouchi
Chiyoda-ku, Tokyo(JP)
Inventor: Nakada, Kiyokazu c/o NKK
CORPORATION
1-2, 1-chome, Marunouchi
Chiyoda-ku, Tokyo(JP)

(74) Representative: Henkel, Feiler, Hänzel &
Partner
Möhlstrasse 37
W-8000 München 80(DE)

(54) Magnetic shield.

(57) A magnetic shield which comprises: a substrate (1); an intermediate layer (2) of silver formed on at least one surface of the substrate; and a film (3) of a composite oxide superconducting material containing a $CuxOy$-radical, formed on the surface of the intermediate layer. The substrate is selected from the group consisting of a paramagnetic metal, a diamagnetic metal and ceramics, and the intermediate layer of silver has a thickness of from 20 to 200 $\mu m$. This magnetic shield has a high strength and a high magnetic shielding effect and can be manufactured at a low cost.

FIG. I

As far as we know, there is available the following prior art document pertinent to the present invention:
"Materials Research Society Proceedings", vol. 99, published in 1988, pp. 695-698, "Super Conducting Tape-Shaped Wire by $Y_1Ba_2Cu_3O_{7-\delta}$ with $Jc \approx 2000$ A/cm²".

The contents of the prior art disclosed in the above-mentioned prior art document will be discussed hereafter under the heading of the "BACKGROUND OF THE INVENTION".

## FIELD OF THE INVENTION

The present invention relates to a magnetic shield which has a high strength and a high magnetic shielding effect, and can be manufactured at a low cost.

## BACKGROUND OF THE INVENTION

In the field of measurement of bio-magnetism for diagnosing a patient on the basis of a feeble magnetism generated from a human body, and in the field of a magnetic prospecting for exploration of mineral resources on the basis of a feeble magnetism generated from rocks, for example, an external magnetism such as geomagnetism present in the environment of an object of magnetic detection and in the environment of a magnetic detector, and a leakage magnetism generated from various electrical appliances, forms a factor causing decrease in a detecting accuracy of such a feeble magnetism.

In order to improve the detecting accuracy of a feeble magnetism, therefore, it is necessary to magnetically shield the object of magnetic detection and the magnetic detector from the external environment by means of a magnetic shield so as to prevent the external magnetism from coming into the object of magnetic detection and the magnetic detector.

A magnetic shield is usually made of a ferromagnetic material such as iron or nickel. By covering the object of magnetic detection and the magnetic detector by means of the magnetic shield made of a ferromagnetic material, most of the external magnetism passes along the magnetic shield without coming into the space surrounded by the magnetic shield, in which the object of magnetic detection and the magnetic detector are placed. A feeble magnetism is therefore detected at a high accuracy without being affected by the external magnetism.

However, while the magnetic shield made of the ferromagnetic material is effective in reducing a relatively strong external magnetism to an intensity of the order of that of geomagnetism, the magnetic shield of this type gives only a poor magnetic shielding effect when it is necessary to largely reduce the intensity of the external magnetism as compared with that of geomagnetism, as in the case of measurement of a feeble magnetism such as bio-magnetism, because the magnetic shield made of the ferromagnetic material has a residual magnetism.

For the purpose of overcoming such an inconvenience, a magnetic shield is conceivable, which comprises a substrate made of stainless steel free from a residual magnetism, and a film of a composite oxide superconducting material such as $Y_1Ba_2Cu_3O_{7-x}$ formed on at least one surface of the substrate by means of the conventional plasma metallizing method.

According to the above-mentioned magnetic shield, it is possible to obtain a high magnetic shielding effect under the Meissner effect of the $Y_1Ba_2Cu_3O_{7-x}$ film, i.e. the diamagnetic effect of completely excluding the external magnetism. In addition, the $Y_1Ba_2Cu_3O_{7-x}$ film has a critical temperature, i.e., the highest temperature at which a superconductive state occurs (hereinafter simply referred to as "Tc"), of approximately 93K. Since liquid nitrogen has a temperature of 77K, liquid nitrogen available at a lower cost than liquid helium can be used as a cooling medium for the $Y_1Ba_2Cu_3O_{7-x}$ film.

However, the above-mentioned magnetic shield has the following problem: Because the substrate is made of stainless steel, the substrate tends to chemically react with the $Y_1Ba_2Cu_3O_{7-x}$ film when forming the film by means of the plasma metallizing method and when heat-treating the film after the formation thereof, thus causing deterioration of the superconducting property of the film.

With a view to overcoming this problem, the "Materials Research Society Proceedings", vol. 99, published in 1988, PP 695-698, "Super Conducting Tape-Shaped Wire by $Y_1Ba_2Cu_3O_{7-\delta}$ with $Jc \approx 2000A/cm^2$" discloses a tape-shaped superconducting wire having an excellent superconducting property (hereinafter referred to as the "prior art").

The superconducting wire of the prior art comprises a substrate made of silver and a film of $Y_1Ba_2Cu_3O_{7-\delta}$ formed on the surface of the substrate.

According to the above-mentioned prior art, since the substrate is made of silver which is difficult to chemically react with the film of composite oxide superconducting material containing a $Cu_xO_y$-radical when forming the film and when heat-treating the film after the formation thereof, the superconducting property of the film is not deteriorated.

However, when applying the above-mentioned prior art to a magnetic shield, the following problem is encountered: The substrate made of silver has a low strength and is expensive. It is therefore difficult to manufacture a large-scale magnetic shield which is capable of receiving a human body such as a magnetic shield for the measurement of biomagnetism, for example.

SUMMARY OF THE INVENTION

An object of the present invention is therefore to provide a magnetic shield which has a high strength and a high magnetic shielding effect, and can be manufactured at a low cost.

In accordance with one of the features of the present invention, there is provided a magnetic shield characterized by comprising:

a substrate; an intermediate layer of silver formed on at least one surface of said substrate; and a film of a composite oxide superconducting material containing a $Cu_xO_y$-radical, formed on said surface of said intermediate layer.

BRIEF DESCRIPTION OF THE DRAWINGS

Fig. 1 is a sectional view illustrating an embodiment of the magnetic shield of the present invention;

Fig. 2 is a perspective view illustrating a stainless steel cylinder forming the magnetic shield in the Example 1 of the present invention;

Fig. 3 is a perspective view illustrating the stainless steel cylinder, which forms the magnetic shield in the Example 1 of the present invention, and has an intermediate film of silver on the outer surface thereof; and

Fig. 4 is a perspective view illustrating the magnetic shield in the Example 1 of the present invention.

DETAILED DESCRIPTION OF PREFERRED EMBODIMENTS

From the above-mentioned point of view, extensive studies were carried out to develop a magnetic shield which has a high strength and a high magnetic shielding effect, and can be manufactured at a low cost.

As a result, the following findings were obtained: By forming an intermediate layer of silver on at least one surface of a substrate having a high strength and free from a residual magnetism, and forming a film of a composite oxide superconducting material containing a $Cu_xO_y$-radical on the surface of the intermediate layer, it is possible to obtain an inexpensive magnetic shield having a high strength and a high magnetic shielding effect.

The present invention was made on the basis of the above-mentioned findings. An embodiment of the magnetic shield of the present invention is described below with reference to the drawings.

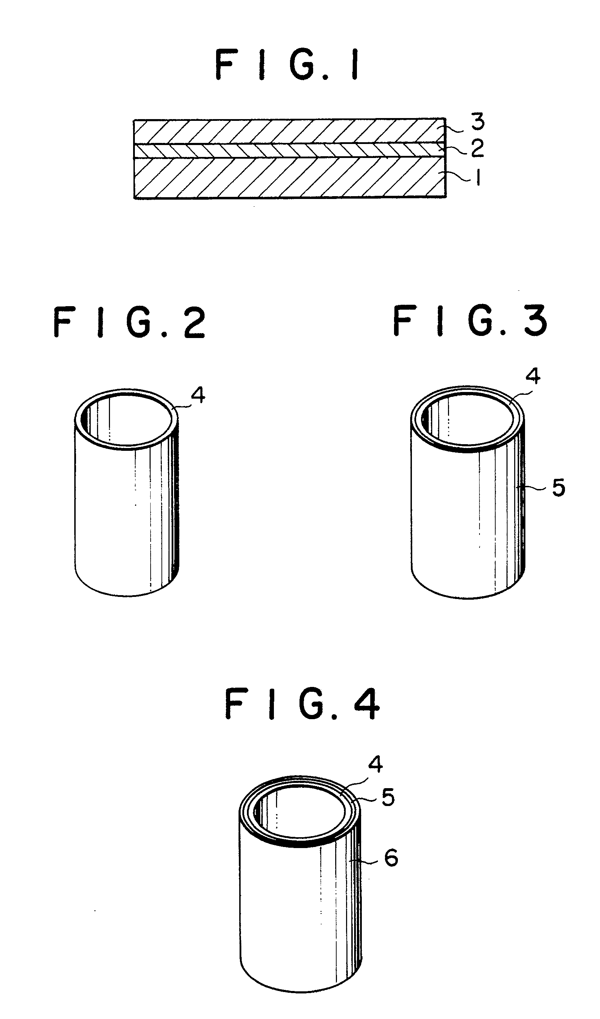

Fig. 1 is a sectional view illustrating an embodiment of the magnetic shield of the present invention.

As shown in Fig. 1, the magnetic shield of the present invention comprises a substrate 1, an intermediate layer 2 of silver formed on one surface of the substrate 1, and a film 3 of a composite oxide superconducting material containing a $Cu_xO_y$-radical, formed on the surface of the intermediate layer 2.

The substrate 1 is made of any one of a paramagnetic metal, a diamagnetic metal and ceramics, all of which have a high strength and are free from a residual magnetism.

The intermediate layer 2 of silver should preferably have a thickness within a range of from 20 to 200 μm in order to ensure prevention of a chemical reaction from taking place between the substrate 1 and the film 3 when forming the film 3 by means of the plasma metallizing method and when heat-treating the film 3 after the formation thereof. The intermediate layer 2 of silver is formed into a uniform thickness on the surface of the substrate 1 by means of a conventional method such as the plasma metallizing method.

The film 3 is made of any one of a Ln-Ba-Cu-O composite oxide superconducting material ("Ln" represents a rare earth element) and a Bi-Sr-Ca-Cu-O composite oxide superconducting material. The film 3 is formed into a uniform thickness on the surface of the intermediate layer 2 by means of a conventional method such as the plasma metallizing method.

According to the magnetic shield of the present invention having the above-mentioned construction, a high strength and a high magnetic shielding effect are available, because the film 3 of a composite oxide superconducting material containing a $Cu_xO_y$-radical is formed on the surface of the substrate 1 having a high strength and free from a residual magnetism through the intermediary of the intermediate layer 2 of silver, and in addition, it is possible to largely reduce the consumption of silver as compared with the case of preparing the entire substrate 1 with silver, thus allowing manufacture of the magnetic shield at a low cost.

Now, the magnetic shield of the present invention is described further in detail by means of examples with reference to the drawings.

EXAMPLE 1

As shown in Fig. 2, a cylindrical substrate 4 made of stainless steel specified in JIS SUS 316L having an inside diameter of 20 mm, a thickness of 1.0 mm and a length of 100 mm was prepared.

Then, the powder of silver having an average particle size within a range of from 26 to 44 $\mu$m was sprayed onto the entire surface of the substrate 4 by the conventional plasma metallizing method to form an intermediate layer 5 of silver having a thickness of 50 $\mu$m on the surface of the substrate 4, as shown in Fig. 3.

Then, the powder of $Y_1Ba_2Cu_3O_{7-x}$ having an average particle size within a range of from 26 to 44 $\mu$m was sprayed onto the entire surface of the intermediate layer 5 of silver by the conventional plasma metallizing method to form a film 6 of $Y_1Ba_2Cu_3O_{7-x}$ having a thickness of 100 $\mu$m on the surface of the intermediate layer 5 of silver, as shown in Fig. 4.

Then, the substrate 4, on the surface of which the film 6 of $Y_1Ba_2Cu_3O_{7-x}$ had thus been formed through the intermediary of the intermediate layer 5 of silver, was heated to a temperature of 900°C for 30 minutes in an electric furnace having an interior atmosphere of oxygen.

Then, the substrate 4, on the surface of which the film 6 $Y_1Ba_2Cu_3O_{7-x}$ having an excellent superconducting property had thus been formed through the intermediary of the intermediate layer 5 of silver, was slowly cooled to a room temperature in the electric furnace.

Investigation of the thus manufactured magnetic shield showed a "Tc" of 89K, and a critical current density, i.e., the largest current density at which a superconducting state can be maintained (hereinafter simply referred to as "Jc") at 77K of 2,000 A/cm², thus revealing an excellent superconducting property.

EXAMPLE 2

As shown in Fig. 2, a cylindrical substrate 4 made of YSZ, i.e., yttrium-stabilized zirconia having an inside diameter of 50 mm, a thickness of 5.0 mm and a length of 200 mm was prepared.

Then, the powder of silver having an average particle size within a range of from 26 to 44 $\mu$m was sprayed onto the entire surface of the substrate 4 by the conventional plasma metallizing method to form an intermediate layer 5 of silver having a thickness of 50 $\mu$m on the surface of the substrate 4, as shown in Fig; 3.

Then, the powder of $Bi_2Sr_2Ca_2Cu_3O_7$ having an average particle size within a range of from 26 to 44 $\mu$m was sprayed onto the entire surface of the intermediate layer 5 of silver by the conventional plasma metallizing method to form a film 6 of $Bi_2Sr_2Ca_2Cu_3O_7$ having a thickness of 100 $\mu$m on the surface of the intermediate layer 5 of silver, as shown in Fig. 4.

Then, the substrate 4, on the surface of which the film 6 of $Bi_2Sr_2Ca_2Cu_3O_7$ had thus been formed through the intermediary of the intermediate layer 5 of silver, was heated to a temperature of 870°C for 200 hours in an electric furnace having an interior atmosphere of oxygen.

Then, the substrate 4, on the surface of which the film 6 of $Bi_2Sr_2Ca_2Cu_3O_7$ having an excellent superconducting property had thus been formed through the intermediary of the intermediate layer 5 of silver, was slowly cooled to a room temperature in the electric furnace.

Investigation of the thus manufactured magnetic shield showed a "Tc" of 103K, and a "Jc" at 77K of 1,000 A/cm², thus revealing an excellent superconducting property.

According to the magnetic shield of the present invention, as described above in detail, a high strength and a high magnetic shielding effect are available, because the film of the composite oxide superconducting material containing a $Cu_xO_y$-radical is formed on the surface of the substrate having a high strength and free from a residual magnetism through the intermediary of the intermediate layer of silver, and in addition, it is possible to manufacture the magnetic shield at a low cost, thus providing industrially useful effects.

**Claims**

1. A magnetic shield characterized by comprising:

a substrate;

an intermediate layer of silver formed on at least one surface of said substrate; and

a film of a composite oxide superconducting material containing a $Cu_xO_y$-radical, formed on said surface of said intermediate layer.

2. A magnetic shield as claimed in Claim 1, wherein:

said substrate comprises any one of a paramagnetic metal, a diamagnetic metal and ceramics.

3. A magnetic shield as claimed in Claim 1 or 2, wherein:

said intermediate layer has a thickness within a range of from 20 to 200 $\mu$m.

4. A magnetic shield as claimed in any one of Claims 1 to 3, wherein:

said film of the superconducting material comprises any one of an Ln-Ba-Cu-O composite oxide superconducting material and a Bi-Sr-Ca-Cu-O composite oxide superconducting material, and said Ln is a rare earth element.

# F I G. 1

# F I G. 2

# F I G. 3

# F I G. 4

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| P,X | PATENT ABSTRACTS OF JAPAN vol. 015, no. 062 (E-1033) 14 February 1991, & JP-A-02 288113 (FURUKAWA) 28 November 1990, * the whole document * | 1,2,4 | H 01 L 39/14 H 01 L 39/24 H 05 K 9/00 G 12 B 17/02 G 01 R 1/18 |
| X | PATENT ABSTRACTS OF JAPAN vol. 014, no. 380 (E-0965) 16 August 1990, & JP-A-02 138799 (HITACHI) 28 May 1990, * the whole document * | 1,2 | |
| A | APPLIED PHYSICS LETTERS. vol. 51, no. 25, 21 December 1987, NEW YORK US pages 2164 - 2166; J. L. MAKOUS ET AL: "Superconducting and structural properties of sputtered thin films of YBa2Cu3O7-x" * page 2164 * | 1,2,4 | |
| A | EP-A-0 312 015 (FURUKAWA) * page 3, line 16 - page 4, line 37; figure 1 * * claim 10, 12 * | 1-4 | |
| D,A | MATERIALS RESEARCH SOCIETY SYMPOSIUM PROCEEDINGS vol. 99, 1988, pages 695 - 698; S. MATSUDA ET AL: "Superconducting tape-shaped wire by Y1Ba2Cu3O7-d with Jc = 2000A/cm2" * the whole document * | 1 | **TECHNICAL FIELDS SEARCHED (Int. Cl.5)** H 01 L |

The present search report has been drawn up for all claims

| Place of search | Date of completion of search | Examiner |
|---|---|---|
| Berlin | 29 August 91 | ROUSSEL A T |